# EUROPEAN PATENT APPLICATION

(11) **EP 2 045 372 A2**
(43) Date of publication of application: **08.04.2009**
(21) Application number: 08015636.7
(22) Date of filing: 04.09.2008
(51) Int. Cl.: C30B 15/30, C30B 29/06

(54) **Method for growing silicon ingot**

(30) Priority: 04.10.2007 KR 20070099677
(71) Applicant: Siltron Inc., Gumi-Si Gyeongsangbuk-Do 730-724 (KR)
(72) Inventor: Hwang, Jung-Ha, Suwon-si, Gyeonggi-do 442-090 (KR); Choi, Il-Soo, Gumi-Si Gyeongsangbuk-DO 730-764 (KR); Kim, Sang-Hee, Gumi-si Gyeongsangbuk, 730-380 (KR)
(74) Representative: Kuhnen & Wacker

(57) **Abstract**

Provided is a method for growing a silicon ingot. According to an exemplary method, the method includes charging silicon in a quartz crucible, melting the silicon by heating the quartz crucible and applying a magnetic field of 500 Gauss or higher in the quartz crucible, and growing a single crystalline silicon ingot from the melted silicon while applying a magnetic field lower than 500 Gauss in the quartz crucible. As a result, by appropriately controlling the internal pressure of the quartz crucible or the application time and the magnitude of the magnetic field, it is possible to easily accelerate crystallization of the internal surface of the quartz crucible to thereby prevent flaking of the crystals. Consequently, it is possible to grow the silicon ingot of good properties.

## Description

### CROSS-REFERENCE TO RELATED APPLICATION

This application claims priority to Korean Patent Application No. 2007-0099677 filed on Oct. 4, 2007 and all the benefits accruing therefrom under 35 U.S.C. §119, the contents of which are incorporated by reference in their entirety.

### BACKGROUND

The present disclosure relates to a semiconductor fabrication process, and more particularly, to a semiconductor wafer fabrication process.

Silicon (Si) wafers are generally fabricated by growing single crystalline silicon using a Czochralski process. The Czochralski process is a method for growing single crystalline silicon, by melting polycrystalline silicon in a quartz crucible to prepare a silicon melt, dipping a silicon seed crystal mounted on a cable into the silicon melt, pulling up the cable slowly while rotating it to obtain a cylindrical lump of single crystalline silicon. Such a lump of single crystalline silicon is referred to as a silicon ingot. A silicon wafer is prepared through a slicing for cutting the silicon ingot perpendicular to the crystal growth direction, a lapping for removing damages caused during the slicing, and a polishing for providing a high flatness to the rough wafer surface. Therefore, in order to fabricate a high quality wafer, growing a high quality silicon ingot is important above all.

As described above, for growing the silicon ingot using the Czochralski process, the polycrystalline silicon needs to be melted in the quartz crucible, and thus, the quartz crucible containing the polycrystalline silicon needs to be heated to a high temperature. Originally, the quartz crucible is an amorphous phase, i.e., a glass phase. However, thermodynamically, the quartz crucible may undergo a phase transformation from an amorphous phase (glass) to a crystalline phase (cristobalite) at a temperature for growing the single crystalline silicon. That is, during the fabrication of the single crystalline silicon ingot, the quartz crucible may undergo partial crystallization. The crystallization of the quartz crucible generally takes place on a surface where a surface energy is higher and material diffusion is easier than inside the quartz crucible, particularly, on an inner surface of the quartz crucible contacting the silicon melt.

The crystallization of the inner surface of the quartz crucible is performed by nucleation at a certain time during the melting of the silicon and growth of the nuclei. The nucleation occurs at a certain time, and then does not occur any more. That is, after the nucleation time, the crystallization of the inner surface of the quartz crucible is performed only by the growth of the nuclei. Accordingly, because the crystallization is not performed uniformly over the inner surface of the quartz crucible, structural difference between a crystallized portion and a non-crystallized portion may cause a flaking of the crystallized portion. The flaked crystals are difficult to melt, and thus, they are not dissolved in the silicon melt, rather are drifted in the silicon melt by convection. Consequently, the flaked crystals may cause a poly-crystallization, reducing the yield of the silicon ingot.

Accordingly, in order to improve the productivity of the silicon ingot, the flaking of the inner surface of the quartz crucible should be prevented. To this end, a method for preventing the crystallization of the inner surface of the quartz crucible and a method for accelerating the crystallization of the inner surface of the quartz crucible are both being researched. Both the methods are designed to prevent the flaking caused by the structural difference between the glass phase and the crystal phase. Both the methods are generally applied from the stage for preparing the crucible. That is, an additional process is required to provide a specific inner surface to the quartz crucible. This may increase the process cost. Furthermore, even though the quartz crucible has been provided with a desired specific inner surface, the specific inner surface may not work well according to the variations of the single crystal growth process.

### SUMMARY

The present disclosure provides a method for growing a silicon ingot which can prevent flaking of inner surface of a quartz crucible without an additional process.

According to an exemplary embodiment, a method for growing a silicon ingot includes: charging silicon in a quartz crucible; melting the silicon by heating the quartz crucible and applying a magnetic field of 500 Gauss or higher in the quartz crucible; and growing a single crystalline silicon ingot from the melted silicon while applying a magnetic field lower than 500 Gauss in the quartz crucible.

According to another exemplary embodiment, a method for growing a silicon ingot includes: charging a silicon in a quartz crucible; melting the silicon by heating the quartz crucible, and applying a magnetic field lower than 500 Gauss before 80 % of the silicon is melted and applying a magnetic field of 500 Gauss or higher after 80 % of the silicon is melted; and growing a single crystalline silicon ingot from the melted silicon while applying a magnetic field lower than 500 Gauss in the quartz crucible.

According to yet another exemplary embodiment, a method for growing a silicon ingot includes: charging a silicon in a quartz crucible; melting the silicon by heating the quartz crucible and maintaining an internal pressure of the quartz crucible at a first pressure ranging from 50 Torr to 400 Torr; and growing a single crystalline silicon ingot from the melted silicon and maintaining the internal pressure of the quartz crucible at a second pressure ranging from 50 Torr to 400 Torr.

### BRIEF DESCRIPTION OF THE DRAWINGS

Exemplary embodiments can be understood in more detail from the following description taken in conjunction with the accompanying drawings, in which:

FIG. 1 is a schematic sectional view of a silicon ingot growth apparatus used in a method for growing a silicon ingot according to an exemplary embodiment;

FIG. 2 is a flowchart illustrating the method for growing the silicon ingot according to the exemplary embodiment;

FIGS. 3A to 3C are schematic sectional views illustrating an operation for melting silicon in a quartz crucible in the method for growing the silicon ingot according to the exemplary embodiment;

FIG. 4 is a schematic sectional view illustrating effect of oxygen in a silicon melt on crystallization of the quartz crucible in the method for growing the silicon ingot according to the exemplary embodiment;

FIG. 5A illustrates a simulation result of convection form when a magnetic field lower than 500 Gauss is applied, and FIG. 5B illustrates a simulation result of convection form when a magnetic field higher than 500 Gauss is applied, in the method for growing the silicon ingot according to the exemplary embodiment;

FIG. 6 illustrates a heat transfer process when a magnetic field is applied in the method for growing the silicon ingot according to the exemplary embodiment; and

FIGS. 7A to 7C are photographs illustrating amounts of flaking in a quartz crucible in the method for growing the silicon ingot according to the exemplary embodiment.

### DETAILED DESCRIPTION OF EMBODIMENTS

Hereinafter, specific embodiments will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In the figures, the shapes of elements are exaggerated for clarity of illustration, and like reference numerals refer to like elements throughout.

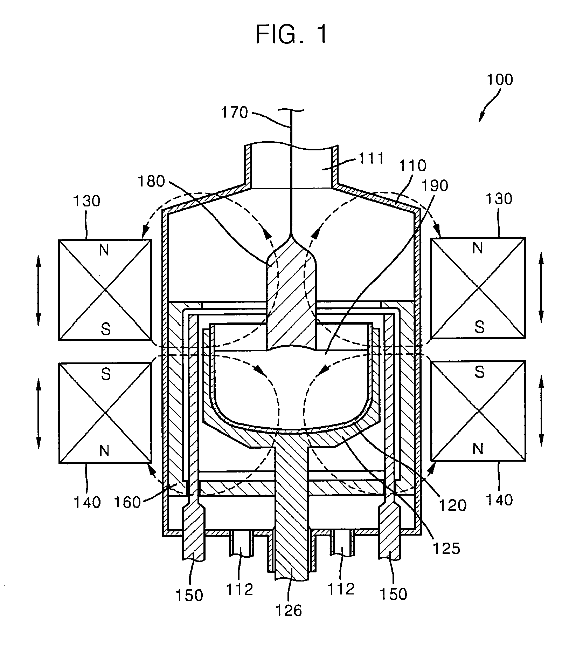

FIG. 1 is a schematic sectional view of a silicon ingot growth apparatus used in a method for growing a silicon ingot according to an exemplary embodiment.

Referring to FIG. 1, the silicon ingot growth apparatus 100 includes a main body 110, a quartz crucible 120, a support 125, an upper electromagnet 130, a lower electromagnet 140, a heater 150, a heat-insulating wall 160 and a cable 170.

The main body 110 includes a receiving portion formed therein, and an outlet 111 disposed in an upper portion of the main body 110 for pulling out a grown silicon ingot 180. The main body 110 further includes a gas inlet (not shown) for supplying an inert gas such as argon (Ar), neon (Ne) and nitrogen (N₂) to a silicon melt 190, and a gas outlet 112 for exhausting a gas therefrom.

The quartz crucible 120 with a receiving portion is placed in the main body 110. Poly-crystalline silicon is contained in the receiving portion of the quartz crucible 120. When the quartz crucible 120 is heated by a heater 150, the poly-crystalline silicon is melted to a silicon melt in the quartz crucible 120.

The support 125 is formed of graphite surrounding the quartz crucible 120 and fixed on a rotation axis 126. The rotation axis 126 is rotated and moved up and down by a driver (not shown), so that the quartz crucible 120 can be moved up while being rotated. The quartz crucible is moved up and down through the rotation axis 120 to keep an interface between the silicon ingot 180 and the silicon melt 190 at a predetermined height.

The upper electromagnet 130 is disposed in an upper portion outside the main body 110, and the lower electromagnet 140 is disposed in a lower portion outside the main body 110. If the upper electromagnet 130 and the lower electromagnet are disposed as shown in FIG. 1, and current or voltage is applied to them, a cusp magnetic field is formed in the quartz crucible 120 as indicated by the arrows.

The heater 150 is formed in a cylindrical shape to surround a side surface of the support 125 with a predetermined gap therebetween. The heater 150 can heat the inside of the quartz crucible 120 to above approximately 1,500 °C to melt the poly-crystalline silicon inside the quartz crucible.

The heat-insulating wall 160 surrounds the heater 150 and the support 125 completely. The heat-insulating wall 160 prevents heat emitted from the heater 150 from being diffused to an outer surface of the main body 110, thereby improving the thermal efficiency. In addition, the heat-insulating wall 160 shields an outer wall of the main body 110 from a high temperature radiation, keeps the temperature inside the main body 110, and maintains the state of the silicon melt 190.

The cable 170 is extended to an upper portion of the main body 110 through the outlet 111 out which a silicon ingot 180 is pulled. To an upper end of the cable 170 is connected a driver (not shown) for rotating and moving up and down the cable 170. On a lower end of the cable 170 is mounted a silicon seed crystal which is dipped into the silicon melt 190 to grow the silicon ingot 180. The driver (not shown) pulls up the cable 170 while rotating the cable 170, during the silicon ingot growth. Here, the cable 170 is rotated in the opposite direction to the rotation of the support 120.

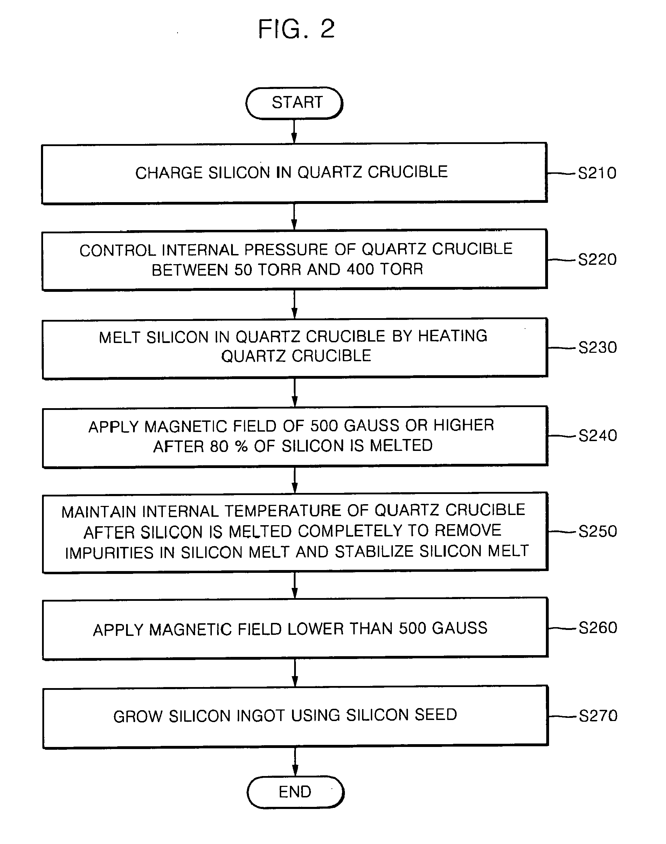

FIG. 2 is a flowchart illustrating the method for growing the silicon ingot according to the exemplary embodiment.

Referring to FIGS. 1 and 2, in operation S210, poly-crystalline silicon is charged in the quartz crucible 120. In general, the poly-crystalline silicon includes a chuck poly or a granule poly. A dopant may also be charged in the quartz crucible 120 together with the poly-crystalline silicon. The dopant determines whether the grown silicon ingot becomes an n-type silicon ingot or a p-type silicon ingot. To grow an n-type silicon ingot, phosphorous (P) or antimony (Sb) may be used as the dopant. To grow a p-type silicon ingot, boron (B) may be used as the dopant.

In operation S220, an internal pressure of the quartz crucible 120 is controlled between 50 Torr and 400 Torr, preferably between 50 Torr and 100 Torr. The internal pressure of the quartz crucible 120 may be controlled by supplying inert gases such as argon, neon, and nitrogen through the gas inlet (not shown).

In operation S230, the quartz crucible 120 is heated by the heater 150 to melt the silicon in the quartz crucible 120.

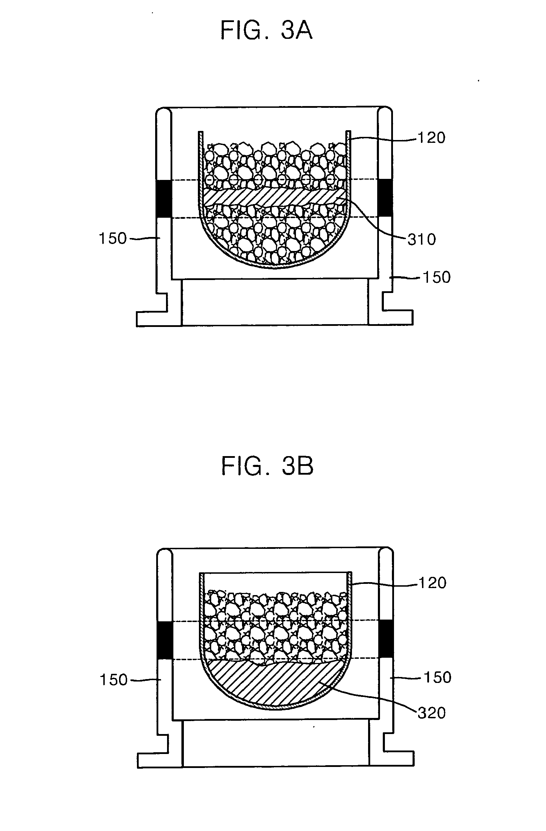

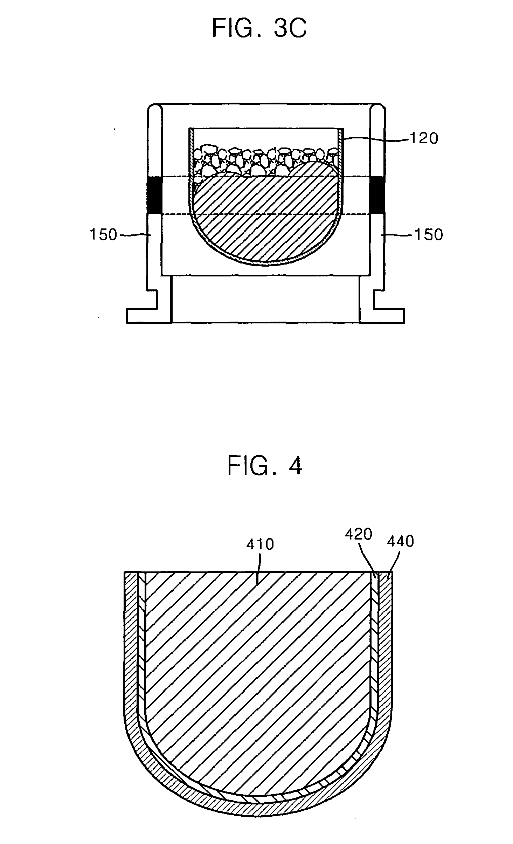

FIGS. 3A to 3C are schematic sectional views illustrating the operation S230 for melting the silicon in the quartz crucible in the method for growing the silicon ingot according to the exemplary embodiment. As shown in FIG. 3A, heat from the heater 150 is concentrated to a certain portion 310 of silicon in the quartz crucible 120 so that the portion 310 is primarily melted. As the amount of melted silicon is increased, a first collapse occurs, and the melted silicon fills the quartz crucible from the bottom as shown in FIG. 3B. Subsequently, as shown in FIG. 3C, the unmelted silicon is collapsed and melted. Here, the unmelted silicon is melted using the heat of the hot silicon melt around the unmelted silicon. That is, the unmelted silicon serves to lower the temperature of the silicon melt. Accordingly, unless sufficient heat is supplied from the heater 150, the unmelted silicon is not melted, rather still remains in the solid state.

Table 1 lists the crystallization degree of the inner surface of the quartz crucible 120 according to the internal pressure of the quartz crucible 120. The crystallization degree of the inner surface of the quartz crucible 120 is represented by an area fraction of the unflaked area in an area of 5 cm x 5 cm in an inner bottom surface of the quartz crucible 120 after the overall process. Here, the magnetic field was controlled to be lower than 300 Gauss throughout from the silicon melting to the silicon ingot growth.

**Table 1**

| | Pressure during silicon melting (Torr) | Pressure during silicon ingot growth (Torr) | Fraction of unflaked area (%) |
|---|---|---|---|
| Example 1 | ≤ 15 | ≤ 40 | 26 |
| Example 2 | 15 ∼ 50 | 50 ∼100 | 74 |
| Example 3 | 50 ∼100 | 50 ∼100 | 88 |
| Example 4 | ≥ 400 | ≥ 400 | - |

As listed in Table 1, when the internal pressure of the quartz crucible 120 was controlled between 50 Torr and 100 Torr during the silicon ingot growth (Examples 2 and 3), the fraction of unflaked area in the internal surface of the quartz crucible 120 was from 74 % to 88 %. However, when the internal pressure of the quartz crucible 120 was controlled to be lower than 40 Torr (Example 1), the fraction of unflaked area in the internal surface of the quartz crucible 120 was only 26 %. Though not shown in Table 1, the case where the internal pressure of the quartz crucible 120 was controlled between 100 Torr and 400 Torr showed similar results to that of the case where the internal pressure was controlled between 50 Torr and 100 Torr.

From the above described results, it was found that the higher the internal pressure of the quartz crucible 120 is, the less the flaking occurs in the internal surface of the quartz crucible 120. This means that as the internal pressure of the quartz crucible 120 is increased, the crystallization is accelerated in the internal surface of the quartz crucible 120. This is probably because of the oxygen concentration in the silicon melt. The effect of oxygen in the silicon melt on the crystallization of the quartz crucible is shown in FIG. 4.

Referring to FIG. 4, when silicon is melted, oxygen is produced inevitably. Hence, an oxygen rich layer 420 is formed inside the silicon melt 410. When the internal surface 440 of the quartz crucible is reacted with the oxygen rich layer 420, the growth of the cristobalite phase may be accelerated. Meanwhile, as the internal pressure of the quartz crucible 120 is increased, oxygen is prevented from being emitted out of the silicon melt. Accordingly, as the internal pressure of the quartz crucible 120 is increased, the crystallization of the inner surface 440 of the quartz crucible is accelerated.

Therefore, in order that more oxygen remains in the silicon melt 190 in the quartz crucible 120, it is preferable to increase the internal pressure of the quartz crucible 120. It is more preferable to control the internal pressure above 50 Torr as shown in Table 1. If the internal pressure of the quartz crucible 120 is greater than 400 Torr as described in Example 4, contaminations may be significantly increased inside the ingot growth apparatus 100. Accordingly, the internal pressure of the quartz crucible 120 is preferably controlled from 50 Torr to 400 Torr, and more preferably, from 50 Torr to 100 Torr.

Particularly, because the melting of the silicon is not a process for growing a single crystal, there is no possibility that poly-crystals are produced or defects are generated by oxides at a pressure from 50 Torr to 400 Torr, preferably from 50 Torr to 100 Torr. Consequently, it is preferable that the pressure is controlled higher during the melting of the silicon than during the growing of the single crystalline silicon, which will be described later.

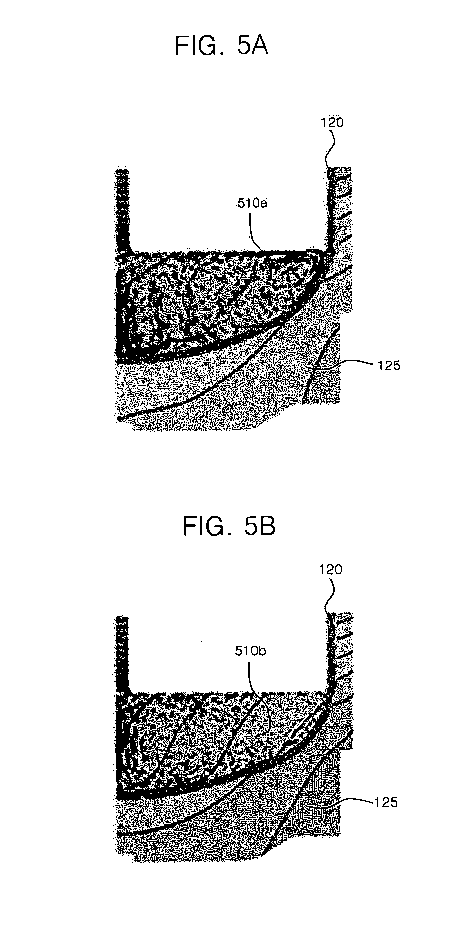

Referring back to FIG. 2, in operation S240, after 80 % or more of the silicon is melted, a magnetic field above 500 Gauss is applied in the quartz crucible 120. Here, a cusp magnetic field is used, which is generated by applying current to the upper electromagnet 130 and lower electromagnet 140 as shown in FIG. 1. By applying the magnetic field while melting the silicon, it is possible to reduce convection inside the melt. Particularly, if the applied magnetic field is higher than 500 Gauss, the convection is significantly reduced, which is shown in FIGS. 5A and 5B.

FIG. 5A illustrates a simulation result of convection form when the magnetic field lower than 500 Gauss is applied, and FIG. 5B illustrates a simulation result of convection form when the magnetic field higher than 500 Gauss is applied, in the method for growing the silicon ingot according to the exemplary embodiment.

Careful investigation of the silicon melts 510a and 510b in the quartz crucible 120 shows that the silicon melt 5 1 ova experienced an active convection as the magnetic field lower than 500 Gauss (FIG. 5A) was applied, whereas, the silicon melt 510b experienced a reduced convection as the magnetic field was increased to above 500 Gauss (FGI. 5B). That is, when a magnetic field of 500 Gauss or higher is applied, the convection in the silicon melt is reduced, resulting in a poor heat transfer in the silicon melt.

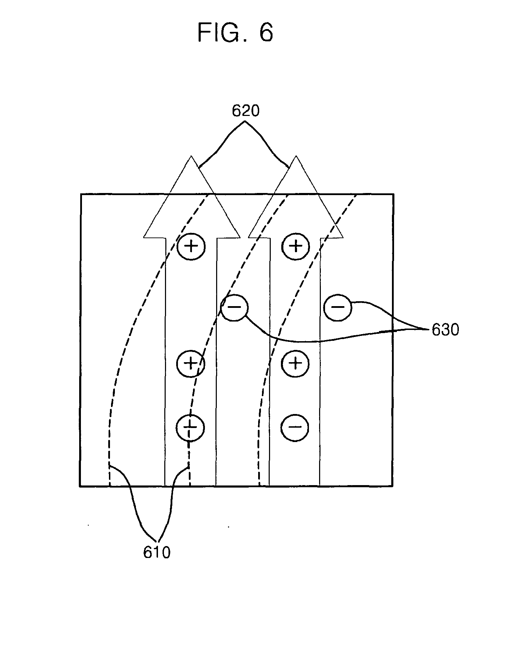

As described above, when a magnetic field of 500 Gauss or higher is applied, electrons 630 are deviated from a heat transfer path 620 by the magnetic field as shown in FIG. 6. This makes the heat transfer in the silicon melt difficult. That is, the heat transfer from the heater 150 to the silicon melt 510b via the support 125 and the quartz crucible 120 is reduced. As a result, the temperature of the peripheral portion of the silicon melt 510b, i.e., the portion of the silicon melt 510b near the quartz crucible 120 is increased in comparison to the typical case, which may accelerate the crystallization of the inner surface of the quartz crucible 120. However, when the applied magnetic field is lower than 500 Gauss, such an effect is not apparent and thus there is no significant effect on the crystallization of the inner surface of the quartz crucible 120.

When a magnetic field of 500 Gauss or higher is applied, convection is prevented in the silicon melt 510b, and thus a heat from the heater 150 is not effectively transferred to the polycrystalline silicon and the silicon melt 510b. Consequently, the melting of the silicon takes approximately two hours to approximately five hours more. Therefore if the magnetic field of 500 Gauss or higher is applied from an initial stage of the melting, time for melting the silicon is increased, and thus the overall process time is also increased. In addition, because, in an initial stage of the silicon melting, heat is applied locally to increase a temperature rapidly from a room temperature to approximately 1,500 °C or higher, the increase in the silicon melting time may cause deformation of the quartz crucible 120. Therefore, it is preferable to apply the magnetic field of 500 Gauss or higher after 80 % or more of the silicon is melted, rather than to apply the magnetic field of 500 Gauss or higher from the initial stage of the silicon melting. When 80 % or more of the silicon is melted, unmelted silicon floats on a surface of the silicon melt. Accordingly, even if the magnetic field of 500 Gauss or higher is applied, the melting time is not increased significantly.

Table 2 lists the crystallization degree of the inner surface of the quartz crucible according to the magnitude of the magnetic field applied in the quartz crucible 120. The crystallization degree of the inner surface of the quartz crucible 120 is represented by an area fraction of the unflaked area in an area of 5 cm x 5 cm in an inner bottom surface of the quartz crucible 120 after the overall process, as described above. Here, the pressure inside the quartz crucible was controlled between 10 Torr and 50 Torr. During the silicon ingot growth, a magnetic field of 300 Gauss or lower was applied.

**Table 2**

| | Magnetic field at initial stage of silicon melting (Gauss) | Magnetic field after 80 % of the silicon was melted (Gauss) | Fraction of unflaked area (%) |
|---|---|---|---|
| Example 5 | ≤ 300 | ≤ 300 | 26 |
| Example 6 | < 500 | ≥ 500 | 100 |
| Example 7 | ≥ 500 | ≥ 500 | 74 |

As listed in Table 2, when a magnetic field of 300 Gauss or lower was applied consistently from an initial stage of the silicon melting (Example 5), the fraction of the unflaked area was low, e.g., 26 %, and thus the crystallization of the inner surface of the quartz crucible 120 was not accelerated. However, when the magnetic field of 500 Gauss or higher was applied after 80 % of the silicon was melted (Examples 6 and 7), the fraction of the unflaked area was significantly increased in comparison to Example 5. This means that the magnetic field of 500 Gauss or higher prevented the convection, and thus accelerated the crystallization of the inner surface of the quartz crucible 120, as described above.

However, if a magnetic field of 500 Gauss or higher is applied from an initial stage of the silicon melting, the overall process time is increased as described above. Therefore, it is more preferable that, as listed in Example 6, a magnetic field lower than 500 Gauss is applied in an initial stage of the silicon melting and a magnetic field of 500 Gauss or higher is applied after 80 % of the silicon is melted. The effect of the magnetic field is not improved any more if it is higher than 500 Gauss, regardless of whether it is 500 Gauss or 1,000 Gauss. Therefore, the magnetic field may have any magnitude range allowable by the ingot growth apparatus 100. However, because, as the magnitude of the magnetic field is increased, the process cost is also increased, it is preferable to apply the lowest magnetic field that can prevent the flaking of the quartz crucible 120.

In order to determine the effect of the magnetic field, the Experiments 5 to 7 in Table 2 were performed at the typical pressure from 10 Torr to 50 Torr. However, it is advantageous to the crystal growth to control the internal pressure between 50 Torr and 400 Torr, preferably between 50 Torr and 100 Torr. This is because, as such, it is possible to increase the oxygen concentration at the inner surface of the quartz crucible 120, and the temperature difference between the inner surface of the quartz crucible 120 and the center of the silicon melt.

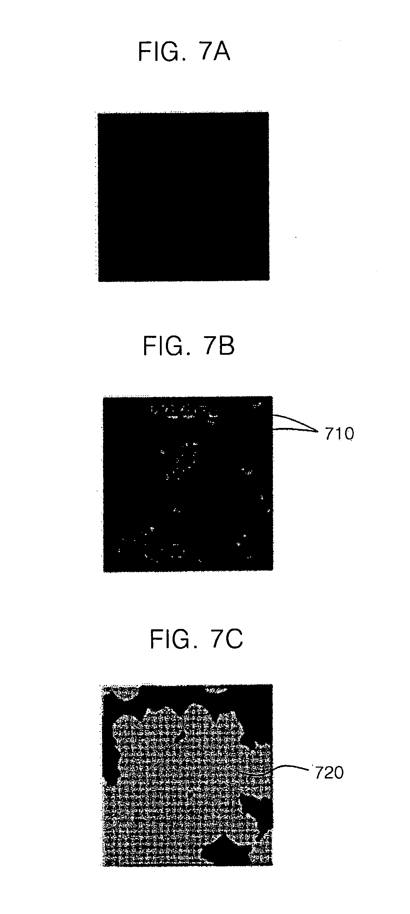

FIGS. 7A to 7C are photographs of the samples of Examples 6, 3 and 5 having a size of 5 cm x 5 cm, respectively. Under the experimental condition of Example 6, no flaking was observed as shown in FIG. 7A. Under the experimental condition of Example 3, the flaking was observed in a certain area 710, which corresponds to 12 % of the overall area, as shown in FIG. 7B. On the contrary, under the experimental condition of Example 5, most of the area 720 was flaked out.

In operation S250, after melting all the silicon, the internal temperature of the quartz crucible 120 is kept constant to remove impurities and stabilize the silicon melt 190.

Thereafter, in operation S260, a magnetic field lower than 500 Gauss is applied in the quartz crucible 120. During the silicon ingot growth, if a magnetic field of 500 Gauss or higher is applied, the growth rate of the silicon ingot and the diameter control is greatly affected, and thus it is difficult to grow a desired single crystal. Accordingly, after the operation S250, the magnetic field is decreased to below 500 Gauss, preferably to below 300 Gauss. However, the pressure is maintained at 50 Torr to 400 Torr, preferably at 50 Torr to 100 Torr.

Although the case where the cusp magnetic field is applied in the quartz crucible has bee described above, the present invention is not limited thereto. For example, the present invention may also be applied to the case where a magnetic field is applied in parallel or perpendicular to the bottom surface of the quartz crucible 120.

Afterwards, in operation S270, the silicon ingot 180 is prepared by performing a dipping process for contacting the silicon seed crystal connected to the cable 170 with the silicon melt, a necking process for growing the single crystalline silicon ingot 180, a shouldering process, and a tailing process for separating the grown silicon ingot 180 from the silicon melt 190.

According to the exemplary embodiments, it is possible to easily accelerate the crystallization of the inner surface of the quartz crucible by appropriately controlling the internal pressure of the quartz crucible, and application time and magnitude of the magnetic field during the melting of the silicon and during the growing of the silicon ingot. Therefore, there is no need for additional process during the preparation of the quartz crucible. In addition, because the crystallization of the inner surface of the quartz crucible is accelerated, the flaking of the quartz crucible can be prevented. As a result, it is possible to improve the property and the yield of the silicon ingot.

Although the method for growing the silicon ingot has(have) been described with reference to the specific embodiments, it(they) is(are) not limited thereto. Therefore, it will be readily understood by those skilled in the art that various modifications and changes can be made thereto without departing from the spirit and scope of the present invention defined by the appended claims.

## Claims

1. A method for growing a silicon ingot, the method comprising:
charging silicon in a quartz crucible;
melting the silicon by heating the quartz crucible and applying a magnetic field of 500 Gauss or higher in the quartz crucible; and
growing a single crystalline silicon ingot from the melted silicon while applying a magnetic field lower than 500 Gauss in the quartz crucible.

2. A method for growing a silicon ingot, the method comprising:
charging silicon in a quartz crucible;
melting the silicon by heating the quartz crucible, and applying a magnetic field lower than 500 Gauss before 80 % of the silicon is melted and applying a magnetic field of 500 Gauss or higher after 80 % of the silicon is melted; and
growing a single crystalline silicon ingot from the melted silicon while applying a magnetic field lower than 500 Gauss in the quartz crucible.

3. The method according to claim 1 or 2, wherein an internal pressure of the quartz crucible is controlled between 50 Torr and 400 Torr.

4. The method according to claim 3, wherein the internal pressure of the quartz crucible is higher during the melting of the silicon than during the growing of the single crystalline silicon ingot.

5. The method according to claim 1 or 2, wherein the magnetic field comprises a cusp magnetic field, a magnetic field parallel to a bottom surface of the quartz crucible, or a magnetic field perpendicular to the bottom surface of the quartz crucible.

6. A method for growing a silicon ingot, the method comprising:
charging silicon in a quartz crucible;
melting the silicon by heating the quartz crucible and maintaining an internal pressure of the quartz crucible at a first pressure ranging from 50 Torr to 400 Torr; and
growing a single crystalline silicon ingot from the melted silicon and maintaining the internal pressure of the quartz crucible at a second pressure ranging from 50 Torr to 400 Torr.

7. The method according to claim 6, wherein the first pressure is higher than the second pressure.
